# EUROPEAN PATENT SPECIFICATION

(11) **EP 3 230 482 B1**
(45) Date of publication and mention of the grant of the patent: **04.03.2020**
(21) Application number: 15816679.3
(22) Date of filing: 03.12.2015
(51) Int. Cl.: C22C 9/00, B32B 15/01, C22F 1/08, C23C 28/02, H01B 1/02, H01L 23/00

(54) **COPPER BASED BONDING WIRE FOR A SEMICONDUCTOR DEVICE**
KUPFERBASIERTER VERBINDUNGSDRAHT FÜR EIN HALBLEITERBAUELEMENT
FIL DE CONNEXION POUR DISPOSITIF À SEMI-CONDUCTEUR

(30) Priority: 11.12.2014 SG 10201408305Y
(43) Date of publication of application: 18.10.2017
(73) Proprietor: Heraeus Deutschland GmbH & Co. KG, 63450 Hanau (DE); Heraeus Materials Singapore Pte., Ltd., Singapur 569871 (SG)
(72) Inventor: SARANGAPANI, Murali, Singapore 760363 (SG); PISIGAN, Legaspi, Singapore 760398 (SG); ZHANG, Xi, Singapore 298190 (SG); YEUNG, Ping Ha, Singapore 457266 (SG); MILKE, Eugen, Nidderau Nidderau (DE)
(74) Representative: Herzog IP Patentanwalts GmbH
(86) International application number: PCT/EP2015/078557
(87) International publication number: WO 2016/091719

(56) References cited:
- JP-A- 2006 307 277
- JP-A- 2010 177 056
- US-A- 5 106 701
- US-A1- 2013 140 084
- US-A1- 2014 209 215

## Description

The present invention relates to the wire defined by claim 1. The present invention further relates to a method for manufacturing the wire as aforementioned and to an electric device comprising the wire of the invention.

Bonding wires are used in the manufacture of semiconductor devices for electrically interconnecting an integrated circuit and a printed circuit board during semiconductor device fabrication. Further, bonding wires are used in power electronic applications to electrically connect transistors, diodes and the like with pads or pins of the housing. While bonding wires were made from gold in the beginning, nowadays less expensive materials are used such as copper. While copper wire provides very good electric and thermal conductivity, ball-bonding as well as wedge-bonding of copper wire has its challenges. Moreover, copper wires are susceptible to oxidation.

With respect to wire geometry, most common are bonding wires of circular cross-section and bonding ribbons which have a more or less rectangular cross-section. Both types of wire geometries have their advantages making them useful for specific applications. Thus, both types of geometry have their share in the market. For example, bonding ribbons have a larger contact area for a given cross-sectional area. However, bending of the ribbons is limited and orientation of the ribbon must be observed when bonding in order to arrive at acceptable electrical contact between the ribbon and the element to which it is bonded. Turning to bonding wires, these are more flexible to bending. However, bonding involves either welding and/or larger deformation of the wire in the bonding process, which can cause harm or even destroy the bonding pad and underlying electric structures of the element, which is bonded thereto.

Some recent developments were directed to bonding wires having a copper core. As core material, copper is chosen because of high electric conductivity. Different dopants to the copper material have been searched for in order to optimize the bonding properties. For example, US 7,952,028 B2 describes several different copper-based test wires with a large number of different dopants and concentrations.

US 2014/0209215 A1 relates to a copper-based alloy wire made of a material selected from the group consisting of a copper-gold alloy, a copper-palladium alloy and a copper-gold-palladium alloy, and manufacturing methods thereof.

US 5,106,701 A relates to a copper alloy wire for electronic applications of no less than 0.01 % by weight of silver and balance copper. The core can be coated with an insulating material, such as a polymer.

JP2010-177056 A relates to a wire for electronic applications comprising a Cu-Ag core. The core can have a coating of a metal such as Ag.

JP2006-307277 A relates to also wire with a Ag metal-plating.

US 2013/140084 A1 discloses a copper based wire comprising elements such as Ag. It is used for bonding in microelectronics, e.g. for stitch- or ball-bonding bond pads.

Nevertheless, there is an ongoing need for further improving bonding wire technology with regard to the bonding wire itself and the bonding processes.

Accordingly, it is an object of the invention to provide improved bonding wires.

It is a further object of the invention to provide a bonding wire which exhibits excellent bondability with respect to a stitch bonding.

It is another object of the invention to provide a bonding wire which has improved resistance to corrosion and/or reliability.

It is a further object of the invention to provide a bonding wire which exhibits an improved reliability and bondability with respect to a ball bonding.

The wires of the present invention have been found to solve at least one of the objects mentioned above. Further, a process for manufacturing these wires has been found which overcomes at least one of the challenges of manufacturing wires. Further, electric devices comprising the wires of the invention were found to be more reliable, both at the interface between the wire according to the invention and other electrical elements, e.g., the printed circuit boards, contact pads, contact pins etc., as well at interfaces within the electric devices, where bonding wires are connected to other electric or electronic parts thus constituting the electric device.

A contribution to the solution of at least one of the above objects is provided by the subject-matter of the category-forming claims. The dependent sub-claims of the category-forming claims represent preferred embodiments of the invention, the subject-matter of which also makes a contribution to solving at least one of the objects mentioned above.

A first aspect of the invention is a wire comprising a core having a composition consisting of:
a1. silver in an amount in the range of from 0.05 to 1.3 wt.%, preferably of from 0.1 to 1.0 wt.% or from 0.2 to 0.8 wt.%; or
a2. Palladium, and at least one element selected from silver and gold,
   wherein the amount of silver is in the range of from 100 ppm to 1.3 wt.%,
   wherein the amount of gold is in the range of from 100 to 1500 ppm, and
   wherein the amount of palladium is in the range of from 0.5 to 1.5 wt.%;
   and
b. copper in the range of from 98 wt.% to 99.95 wt.%, preferably from 98.5 wt.% to 99.6 wt.%, and most preferably from 99.4 wt.% to 99.6 wt.%;
c. 0 to 100 ppm of further components which are different from the elements silver, gold, palladium and copper;
wherein all amounts in wt.% and ppm are based on the total weight of the core;
wherein the core has an average size of crystal grains in the range of from 3 to 30 µm, or from 3 to 20 µm, or from 5 to 15 µm, the average size determined according to the line intercept method;
wherein the wire has an average diameter in the range of from 8 to 80 µm, or in the range of from 12 to 55 µm;
wherein the core (2) has a surface (15), wherein a coating layer (3) is superimposed over the surface (15) of the core (2);
wherein the coating layer (3) is composed of at least one element selected from the group consisting of palladium, platinum and silver;
wherein a further coating layer (4) is superimposed over the coating layer (3);
wherein gold is the component of the further coating layer (41).

The wire is preferably a bonding wire for bonding in microelectronics. The wire is preferably a one-piece object. Numerous shapes are known and appear useful for wires of the present invention. Preferred shapes are - in cross-sectional view - round, ellipsoid and rectangular shapes.

The core of the wire of the invention comprises 0 to 100 ppm of further components. The low amount of these further components ensures a good reproducibility of the wire properties. In the present context, the further components, often also referred as "inevitable impurities", are minor amounts of chemical elements and/or compounds which originate from impurities present in the raw materials used or from the manufacturing process which produced the wire. Examples of such further components are: Ni, Mn, Pt, Cr, Ca, Ce, Mg, La, Al, B, Zr, Ti, S, Fe.

In line with the aforementioned, an embodiment of the invention is a wire comprising a core comprising components selected from a1. and a2, and further, as a remainder, copper (i.e., component b). Further components present in the core are usually not added separately. The presence of the further components originates from impurities present in one or more of components a1., a2. and b.

In a preferred embodiment, the core of the wire of the invention comprises less than the following amounts of further components:
a) Any one of Ni, Mn in <15 ppm each;
b) Any one of: Pt, Cr, Ca, Ce, Mg, La, Al, B, Zr, Ti in <2 ppm each;
c) Any one of S, Fe in <10 ppm each;

Yet more preferred at least two of the aforementioned limits are met by the material forming the core, most preferred all limits are met by the material forming the core.

The core of the wire in the present context is defined as a homogenous region of bulk material. Since any bulk material always has a surface region which might exhibit different properties to some extent, the properties of the core of the wire are understood as properties of the homogeneous region of bulk material. The surface of the bulk material region can differ in terms of morphology, composition (e.g. oxygen content) and other features. The surface can be an outer surface of the inventive wire in preferred embodiments. In further embodiments, the surface of the wire core can be an interface region between the wire core and a coating layer superimposed on the wire core.

The term "superimposed" in the context of the present invention is used to describe the relative position of a first item, e.g. a copper core, with respect to a second item, e.g. a coating layer. "Superimposed" characterizes, that further items, such as an intermediate layer, can - but no need to be arranged between the first and the second item. Preferably, the second item is at least partially superimposed over the first item, e.g. for at least 30 %, 50 %, 70 % or for at least 90 %, each with respect to the total surface of the first item. Most preferably, the second item is completely superimposed over the first item.

The term "intermediate layer" in the context of this invention refers to a region of the wire between the copper core and the coating layer. In this region, a combination of materials of both, the core and the coating layer, is present.

The term "thickness" in the context of this invention is used to define the size of a layer in perpendicular direction to the longitudinal axis of the copper core, which layer is at least partially superimposed over the surface of copper core.

The average diameter is obtained by the "sizing method". According to this method the physical weight of the wire for a defined length is determined. Based on this weight, the diameter of the wire is calculated using the density of the wire material (density of copper: ρ_{Cu} = 8.92 g/cm³). The average diameter is calculated as arithmetic mean of five measurements on five cuts of a particular copper wire.

For the present invention, the term bonding wire comprises all shapes of cross-sections and all usual wire diameters, though bonding wires with circular cross-section and thin diameters are preferred.

The line intercept method for determining the average size of crystal grains is a standard metallographic practice. There, a wire is cut perpendicular to the direction of the wire and the cross-section generated thereby is etched. The size of a crystal grain in the present context is defined as the longest of all sections of straight lines which can be passed through the grain. The average size of crystal grains is the arithmetic mean of at least seven measurements of crystal grains in the core / bulk material. The testing is performed according to ASTM E112-96 standard, section 16.3, page 13.

In a further preferred embodiment of the invention, the wire core comprises elemental phosphorus in the range of from 40 to 80 ppm, based on the total weight of the core.

In a further preferred embodiment of the invention, the amount of silver in the core is in the range of from 0.475 and 0.525 wt.%, and the amount of elemental phosphorus is in the range of from 40 to 80 ppm, the wt.% and ppm based on the total weight of the core.

In a further preferred embodiment of the invention, the ratio between the diameter of the core and the average size of crystal grains in the core is in the range of from 2 to 10, more preferred between 2.5 and 5.

In a further preferred embodiment of the invention, the average diameter of the wire is in the range of from 15 to 28 µm. In this case, the average size of crystal grains is preferably in the range of from 3 to 6 µm.

In another preferred embodiment of the invention, the average diameter of the wire is in the range of from 28 to 38 µm. In this case, the average size of crystal grains is preferably in the range of from 4 to 10 µm.

In another preferred embodiment of the invention, the average diameter of the wire is in the range of from 38 to 50 µm. In this case, the average size of crystal grains is preferably in the range of from 8 to 15 µm.

In a further preferred embodiment of the invention, the mass of the coating layer is not more than 2.5 wt.%, preferably 2 wt.% or less, each with respect to the total mass of the core. When a coating layer is present, it often has a minimum mass of about 0.1 wt.% or more or 0.5 wt.% or more, each with respect to the total mass of the core. Applying a low amount of material as coating layer preserves the characteristics which are defined by the material of the core of the wire. On the other hand, the coating layer award particular characteristics to the wire surface such as being inert against environment, resistance to corrosion, improved bondability, etc. For example, the thickness of the coating layer is in the range of from 60 to 70 nm for a copper wire of a diameter of 18 µm. For a wire with diameter of 25 µm, the coating layer has a thickness of 90 to 100 nm.

As mentioned before and according to the invention, the coating layer is made of an element selected from the group consisting of palladium, platinum and silver. The coating layer can be a monolayer of one of the aforementioned elements. In another embodiment, the coating layer can be a multilayer of a number of super-positioned layers, wherein each layer is made of one of the aforementioned elements. Each layer which is part of the coating layer is de-positioned individually from one of the aforementioned pure metal elements. Common techniques for deposition of these elements on the core are plating, such as electroplating and electroless plating, deposition of the material from the gas phase such as sputtering, ion plating, vacuum evaporation and physical vapor deposition, and deposition of the material from the melt.

As mentioned before and according to the invention,, a further coating layer is superimposed over the coating layer. In a further preferred embodiment of the invention, the mass of the further coating layer is not more than 0.2 wt.%, preferably not more than 0.1 wt.%, each with respect to the total mass of the core.

For example, the thickness of the further coating layer is in the range of from 2 to 4 nm for a copper wire of a diameter of 18 µm. For a wire with diameter of 25 µm, the further coating layer has a thickness of 3.5 to 5.5 nm.

As mentioned before, gold is the component of the further coating layer according to the invention.

In a further preferred embodiment of the invention, the wire of the invention is characterized at least by one of the following features:
α) In an annealing curve (a graph showing elongation in % as a function temperature), the elongation value ΔL is not more than 95 %, preferably not more than 80 %, each with respect to the maximum elongation observed in an annealing curve of the wire ΔLₘₐₓ;
β) The hardness of the wire core is not more than 105 HV (0.01N/5s), preferably not more than 100 HV (0.010N/5s), or not more than 95 HV (0.010N/5s).
γ) The process window area for stitch bonding has a value of at least 90 µm*g, or at least 160 µm*g, or of at least 200 µm*g, each provided the wire has a diameter of 18 µm.

A second aspect of the invention is a method for manufacturing a wire, preferably a bonding wire, preferably useful for bonding in microelectronics, the wire preferably being of a desired diameter, wherein the wire is a wire as defined according to the first aspect of the invention, the method comprising at least the steps of
i. Providing a precursor item having a composition comprising:
   a1. silver in an amount in the range of from 0.05 to 1.3 wt.%; or
   a2. Palladium, and further at least one of silver and gold,
      wherein the amount of silver is in the range of from 100 ppm to 1.3 wt.%,
      wherein the amount of gold is in the range of from 100 to 1500 ppm, and
      wherein the amount of palladium is in the range of from 0.5 to 1.5 wt.%;
   b. copper in the range of from 98 wt.% to 99.95 wt.%, preferably from 98.5 wt.% to 99.6 wt.%, and most preferably from 99.4 wt.% to 99.6 wt.%;
   c. 0 to 100 ppm of further components which are different from the elements silver, gold, palladium and copper;
   wherein all amounts in wt.% and ppm are based on the total weight of the precursor;
ii. elongating the precursor item to form a wire precursor, until the desired diameter of the wire core is obtained;
iii. annealing the wire precursor, preferably in a tubular oven;
whereby the wire is obtained.

Preferred embodiments of the second aspect of the invention are those, which have been described for the first aspect of the invention in the above. A precursor item as in step a1. and a2. can be obtained by doping copper with the cited amounts of al.: silver, or a2.: palladium and at least one of silver and gold. Doping is realized by producing a melt of said components and copper and cooling the melt to form a homogeneous piece of copper based precursor item.

The coating layers being present on the wire as described for some of the embodiments of the first aspect of the invention, are preferably applied to the wire precursor. The skilled person knows how to calculate the thickness of such coating layers on a precursor item to obtain the coating layers in the thickness described for the embodiments of the wire, i.e. after elongating the precursor with the coating layers to the wire. Numerous techniques for forming a coating layer of a material according to the embodiments on a copper surface are known. Preferred techniques are plating, such as electroplating and electroless plating, deposition of the material from the gas phase such as sputtering, ion plating, vacuum evaporation and physical vapor deposition, and deposition of the material from the melt.

Numerous techniques are known to elongate a precursor item to form a wire precursor are known and appear useful in the context of the present invention. Preferred techniques are rolling, swaging, die drawing or the like, of which die drawing is particularly preferred. More preferably, the precursor item is drawn in 8 major stages and each stage with 15 to 25 steps, wherein in each drawing step an elongation of the precursor item in the range of from 6 to 18 % in length is performed. The % of elongation may be same or different for each drawing step. A slipping agent may be employed. Suitable slipping agents are numerous and known to the skilled person.

In a preferred embodiment of the second aspect of the invention, the precursor item further comprises phosphorus in the range of from 40 to 80 ppm.

Numerous procedures are known in the art to anneal a wire, e.g. annealing of wire can be performed in both, a continuous or in a discontinuous process. In special applications, continuous and discontinuous processes may even be combined.

According to another aspect of the invention the annealing speed is chosen in the range of from 4 to 30 metre/min., or from 14 to 16 metre/min.

In a preferred embodiment of the second aspect of the invention, the annealing step iii. is strand annealing. Strand annealing is a continuous process which allows for a fast production of the wire with high reproducibility. Strand annealing means that the annealing is done dynamically while the wire is moved through a tubular annealing oven and spooled onto a reel after having left the oven.

In a further preferred embodiment of the second aspect of the invention, step iii. is performed under at least one of the following conditions:
aa. at a temperature in the range of from 570 to 740 °C, or
bb. for a period in the range of from 0.1 s to 0.4 s,
cc. at a temperature in the range of from 570 to 740 °C and for a period in the range of from 0.1 s to 0.4 s.

In a further preferred embodiment of the second aspect of invention, the wire precursor is annealed at a temperature of at least 570 °C for a time of at least 0.1 s prior. This is one way to ensure a sufficient annealing and achievement of the demanded grain size, in particular in the case of thin wires. Even more preferred, the annealing time is at least 0.2 s and most preferred 0.25 s. The annealing temperature in step iii. allows for the adjusting the average grain size. In a most preferred case the annealing temperature is chosen above 600 °C.

In another preferred embodiment of the second aspect of the invention, step iii. is performed at a temperature which is at least 10 °C, preferably at least 50 °C, or at least 80 °C higher than the temperature of maximum elongation T_{ΔL(max)}. Often, the temperature in step iii. is not more than 120 °C higher than T_{ΔL(max)}.

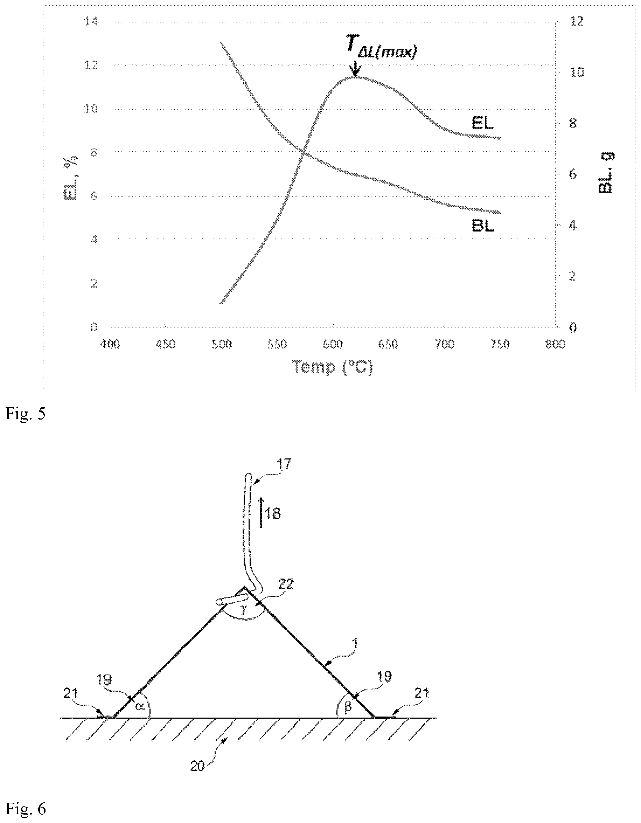

The temperature of maximum elongation T_{ΔL(max)} is determined by testing the elongation at break of a specimen (wire) at different temperatures. The data points are collected in a graph, showing the elongation (in %) as a function of temperature (°C). The resulting graph is often referred to as an "annealing curve". In the case of copper based wires, a temperature is observed where the elongation (in %) reaches a maximum. This is the temperature of maximum elongation T_{ΔL(max)}. An example is shown in Figure 6.

Up to now, wires were usually annealed at the temperature of maximum elongation, as the presence of a local maximum at a specific temperature provides for a particularly stable manufacturing condition.

With respect to this embodiment of the present invention, it was found that annealing at a value of elongation below the maximum elongation value can result in beneficial wire properties as the wire morphology can be influenced in a positive way. Further, it has been found that selecting the annealing temperature to be higher than the temperature of maximum elongation while maintaining the annealing time constant, is of further advantage. For example, this manufacturing principle can be used to adjust the average grain size of the wire, e.g. to larger grain sizes. By this adjustment, other properties like e.g. wire softness, ball-bonding behavior etc. can be influenced in a positive manner.

According to another aspect of the invention, the annealing in the tube furnace may be performed in an inert atmosphere or a reducing atmosphere. This applies to both annealing in continuous as well as discontinuous processing. Numerous types of inert atmospheres as well as reducing atmospheres are known in the art. Of the known inert atmospheres, nitrogen is preferred. Of the known reducing atmospheres, hydrogen is preferred. Another preferred reducing atmospheres is a mixtures of hydrogen and nitrogen. Preferred mixtures of hydrogen and nitrogen are composed of in the range of from 90 to 98 %-Vol. nitrogen and in the range of from 2 to 10 Vol-% hydrogen, each referring to the total volume of the mixture. Preferred mixtures of nitrogen/hydrogen are equal to 93/7, 95/5 and 97/3 Vol-%/Vol-%, each based on the total volume of the mixture. Applying reducing atmospheres in annealing is particularly preferred, if some parts of the surface of the wire are sensitive to oxidation by oxygen of the air, e.g. if copper of the wire is exposed to its surface.

The invention also comprises a wire obtainable by a method according to the second aspect of the invention or of an embodiment thereof.

A third aspect of the invention is an electric device comprising at least
(1) a first bonding pad;
(2) a second bonding pad; and
(3) a wire according to the first aspect of the invention, or a wire obtainable by a method according to the second aspect of the invention;
wherein the wire is electrically connected to at least one of the bonding pads.

Preferably, the wire is connected to the first bonding pad by ball-bonding. For bonding to the second pad, stitch bonding is preferred.

In a preferred embodiment of the fourth aspect of the invention, the electric device comprises at least a module, comprising a first bonding pad, a second bonding pad and at least one wire of the invention, wherein the wire is connected to one of the bonding pads by means of ball-bonding. The electric device can be an integrated circuit, a light emitting diode (LED), a display device or the like.

A fourth aspect of the invention is a propelled device comprising at least one electrical device according to the third aspect of the invention. Examples of propelled devices are airplanes, motorised vehicles like cars, trucks, tanks, ships, submarines, wind turbines and power generators.

A fifth aspect of the invention is a method for making an electric device
1) Providing at least two elements as mentioned above,
2) Connecting the two elements through a wire according to the first aspect of the invention, wherein at least one of said connections is performed by ball bonding. Preferably, the first bonding is a ball bonding. The second bonding can be formed by wedge bonding.

Both, wedge bonding and ball bonding technology is known in the art and extensively described in the literature, e.g. in Shankara K. Prasad, "Advanced Wirebond Interconnection Technology", Kluwer Academic Publishers, 2004, ISBN 1-4020-7762-9, in particular chapter I (introduction) and chapter IV (process technology).

### Description of Figures

The subject matter of the invention is exemplified in the figures. The figures, however, are not intended to limit the scope of the invention or the scope of the claims in any way.
In Figure 1, a wire 1 is depicted.

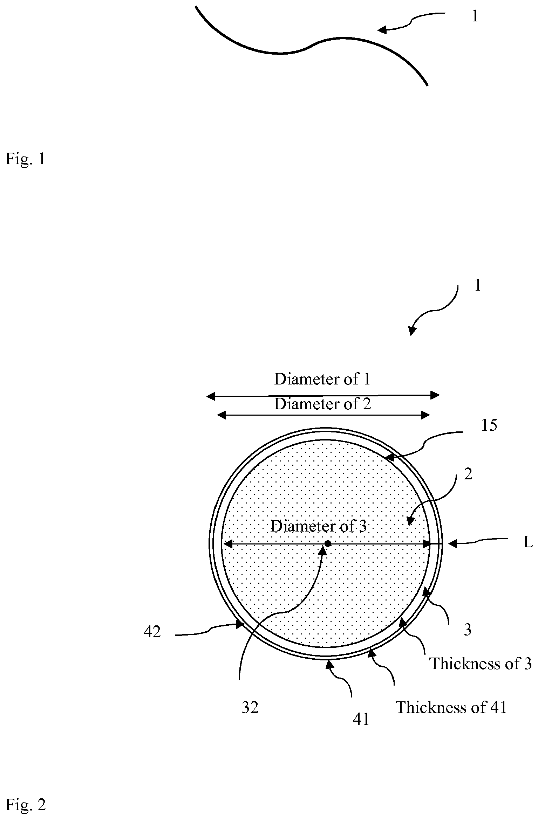

Figure 2 shows a cross sectional view of wire 1. In the cross sectional view, a copper core 2 is in the middle of the cross sectional view. The core 2 is encompassed by a coating layer 3. The coating layer 3 is encompassed by a thin flash coating layer 41. The limit of core 2 facing coating layer 3 is surface 15. The limit of coating layer 3 facing flash coating layer 41 is surface 42. On a line L through the center 32 of wire 1 the diameter of core 2 is shown as the end to end distance between the intersections of line L with the surface 15. The diameter of wire 1 is the end-to-end distance between the intersections of line L through the centre 23 and the outer limit of wire 1, here surface 42. In addition, thickness of coating layer 3 and flash coating layer 41 are depicted. The thickness of a coating layer 3 is not proportional with respect to the core in fig. 2. Typically, the thickness of coating layer 3 is very small compared to the core diameter, e.g. less than 1% of the core diameter. Similarly, the thickness of flash coating layer 41 is not proportional. It is denoted that coating layer 3, coating layer 41 of wire 1 are embodiments of the present invention. These layers are no necessary part of the present invention. The most preferred aspect of the invention is a wire core with no coating layer on the wire core.

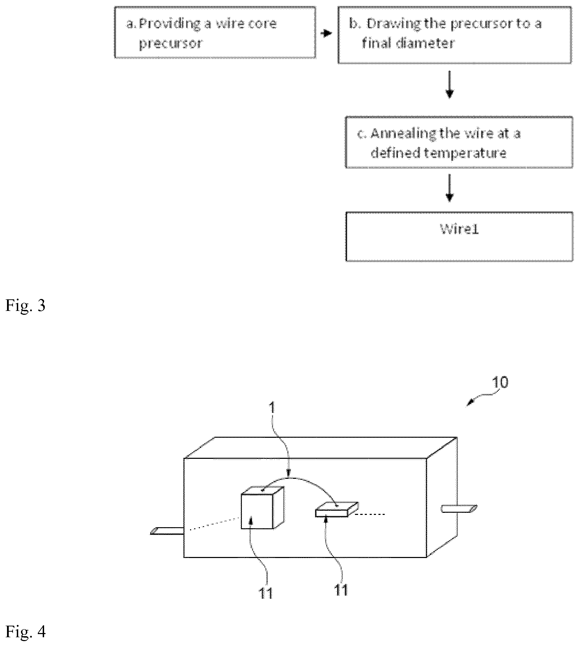

Figure 3 shows a process for manufacturing a wire according to the invention.
Figure 4 depicts an electric device 10, comprising two elements 11 and a wire 1. The wire 1 electrically connects the two elements 11. The dashed lines mean further connections or circuitry which connects the elements 11 with external wiring of a packaging device surrounding the elements 11. The elements 11 can comprise bond pads, integrated circuits, lead fingers, LEDs or the like.
Figure 5 shows an exemplary annealing curve of a silver-alloyed 18 µm copper wire, sample 2 (Table 1). The annealing temperature is the variable parameter of the x-axis. The graph shows the measured values of the break load (BL, in grams) and the elongation (EL, in %) of the wire. The elongation was determined by tensile testing. Elongation measurements exhibited a typical local maximum value of about 11.5 % in the displayed example, which was achieved at an annealing temperature of around 610 °C. The inventive wire according to sample 2 was not annealed at this temperature of maximum elongation, but at 650 °C (sample 2), which was 40 °C above the temperature of the maximum elongation according to figure 6. This results in an elongation value of about 9.3%, which is more than 10% below the maximum elongation value.
Figure 6 depicts a sketch of a wire pull test. To a substrate 20, a wire 1 is bonded in bonds 21 at an angle 19 of 45°. A pull hook 17 pulls wire 1. The angle 22, which is formed when the pull hook 17 pulls the wire 1, is 90°.
Figure 7 shows 2^{nd} bond window comparison between inventive and reference wires.
Figure 8 shows a schematic diagram of a strand annealing device Wire 1 is unrolled from reel 25 via wheel 26 through annealing oven 24, then guided over another wheel 26 and rolled on stock reel 23.
Figure 9 illustrates grain size measurements carried out in the present invention as per ASTM standard E112-96, section 16.3, page 13. G_{FAB} is the grain size of the FAB, G_{W} is the grain size of the Wire, L_{FAB} is the length of the intercept line marked in a FAB, L_{W} is the length of the intercept line marked in the wire, N_{FAB} is the number of grains intersecting the line, and N_{W} is the number of grains intersecting the line.

### Examples

The invention is further exemplified by examples. These examples serve for exemplary elucidation of the invention and are not intended to limit the scope of the invention defined by the claims in any way.

### Example 1

A quantity of copper (Cu) material of at least 99.99 % purity ("4N-copper") was melt in a crucible. A small amount of master alloy was added to the copper melt and uniform distribution of the added component was ascertained by stirring. A master alloy comprises Cu and one further element in a defined ratio. The following master alloys were used.

| Name of Master Alloy | Composition | |
|---|---|---|
| Cu-15wt%Ag | 85 wt.% Cu | 15 wt.% Ag |
| Cu-0.5wt%P | 99.5 wt.% Cu | 0.5 wt.% P |
| Cu-15wt%Pd | 85 wt.% Cu | 15 wt.% Pd |
| Cu-1wt%Au | 99 wt.% Cu | 1 wt.% Au |

For instance, Cu-15wt%Ag was added to samples 1 to 3, Cu-15wt%Ag and Cu-0.5wt%P were added to process samples 4 and 5, Cu-15wt%Pd and Cu-1wt%Au were added to process samples 7 to 9, Cu-15wt%Ag and Cu-15wt%Pd were added to process samples 10 to 11, Cu-15wt%Ag, Cu-1wt%Au and Cu-15wt%Pd were added to process samples 12 to 13, Cu-15wt%Ag, Cu-0.5wt%P and Cu-15wt%Pd were added to process samples 14 to 17. Then a wire core precursor was continuous cast from the melt.

The chemical composition of the Cu wire was controlled using an inductively coupled plasma (ICP) instrument using Perkin Elmer ICP-OES 7100DV model. The Cu wires were dissolved in concentrated nitric acid and the solution was used for ICP analysis. The methodology to test highly pure Cu wire was established with the equipment manufacturer as per the well-known technique adopted for bulk Cu. The composition of the master alloys were also controlled using ICP analysis. The amounts of further components, i.e. around 0.1 ppm Mn, 1 ppm P and/or Ni, ≤ 2 ppm Fe and the amount of < 5 ppm S in Table 1, 3 and 5 originate from impurities present in the copper and/or the master alloys.

The wire core precursor was then drawn in 6 major drawing stages with 22 steps in each stage to form a wire core with an average diameter of 18 µm, wherein an elongation of the precursor item of from 6 to 18 % in length was performed in each step. In the examples presented herein, 17% elongation was practised for stage 1, 11% elongation was practised for stage2 to stage 5 and 8% elongation was practised for stage6. A slipping agent was employed during drawing.

The cross section of the wire core was of circular shape. The wire had an average diameter of 18 µm. The average diameter was determined by individual measurements of diameter at different spots of the wire which led to measurement results in the range of from 17.5 to 18.5 µm.

By means of this procedure, several samples of an inventive wire and a comparative wire (Ref) were manufactured.

**Table 1: Chemical composition of the copper alloy, wire average diameter 18 µm, values in ppm**

| Sample | Ag | Pd | Au | P | Ni | s | Fe | Mn |
|---|---|---|---|---|---|---|---|---|
| 4N Cu (Ref1) | 12 | 0.5 | 0.5 | 1.0 | 1.0 | 2.0 | 2.0 | 0.1 |
| 3N Cu (Ref2) | 225 | 0.5 | 0.5 | 1.0 | 1.0 | 2.0 | 2.0 | 0.1 |

| Good bondability (2^{nd} bond) | | | | | | | | |
|---|---|---|---|---|---|---|---|---|
| 1 | 1010 | 0.5 | 0.5 | 1.0 | 1.0 | 2.0 | 1.4 | 0.1 |
| 2 | 5020 | 0.5 | 0.5 | 1.0 | 1.0 | 2.0 | 1.6 | 0.1 |
| 3 | 10300 | 0.5 | 0.5 | 1.0 | 1.0 | 2.0 | 1.1 | 0.1 |
| 4 | 4960 | 0.5 | 0.5 | 78 | 1.0 | 4.3 | 1.5 | 0.1 |
| 5 | 10020 | 0.5 | 0.5 | 74 | 1.0 | 4.4 | 1.8 | 0.1 |

Table 1 shows the composition of different samples numbered from 1 to 5 of an inventive wire of 18 µm average diameter. The silver content of the wires varied as indicated as did the amount of phosphorus. Comparative (Ref1 and Ref2) wires consisting of copper of 4N (purity: Cu ≥ 99.99 wt.%) and 3N (purity: Cu ≥ 99.9 wt.%) (non-inventive) purity were added for references.

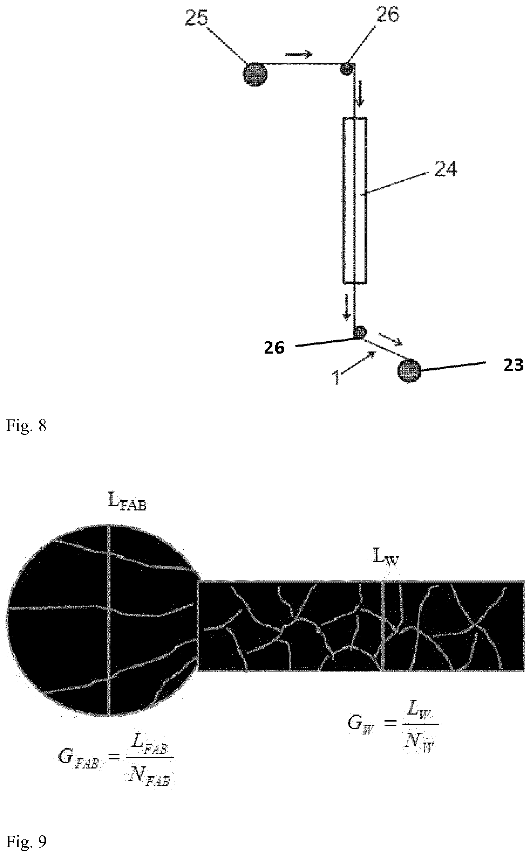

The wires were then annealed in a final annealing step. The annealing was performed dynamically as strand annealing, by running the wire 1 through an annealing oven (see figure 8) of a length= 30cm and an annealing temperature of 650°C with a speed of 1m/s. After leaving the oven the wire was spooled on a reel for packaging.

In the present examples the annealing time was the exposure time a given piece of the moving wire remains within the heated oven, which was 0.3 s. Within the oven zone, a constant temperature was adjusted.

Figure 5 shows an exemplary annealing curve of a silver-alloyed 18 µm copper wire, sample 2 (Table 1). The annealing temperature is the variable parameter of the x-axis. The graph shows the measured values for the break load (BL, in grams) and the elongation (EL, in %) of the wire. The elongation was determined by tensile testing. Elongation measurements exhibited a typical local maximum value of about 11.5 % in the displayed example, which was achieved at an annealing temperature of around 610 °C (temperature of maximum elongation). The inventive wire according to sample 2 was not annealed at this temperature of maximum elongation, but at 650 °C (sample 2), which is 40 °C above the temperature of the maximum elongation. This results in an elongation value of about 9.3%, which is more than 10% below the maximum elongation value. Annealing at a temperature higher than the temperature of maximum elongation (T_{ΔL(max)}) means to work in a rather sensitive range of the material in terms of process parameters. In order to have a good reproducibility of the results, the entire set of parameters were monitored carefully. For sample No. 2, the average grain size was 4 µm.

Further experiments have shown that for wires with diameters in the range of 15 to 28 µm, an average crystal grain size in the range of 3 to 6 µm was achieved for the entire range of added silver content, i.e. from 0.1wt% to 1.3wt%.

Table 2 below shows results of an evaluation on stitch bonding performance (stitch pull bonded wires as shown in Figure 6). The above wire samples 1-5 as well as the comparative example of a pure Cu wire, doped Cu wire and an Au Flash Pd coated Cu wire (AFPC) were tested for stitch bonding as described under below "test methods".

**Table 2: 2^{nd} bond (stitch bond) process window**

| **Wire sample** | **4N Cu (Ref1)** | **3N Cu (Ref2)** | **AFPC (Ref3)** | **1** | **2** | **3** | **4** | **5** |
|---|---|---|---|---|---|---|---|---|
| Scrub amplitude (µm) | 2-4 | 2-4 | 2-5 | 2-4 | 2-5 | 2-5 | 2-5 | 2-5 |
| Force (g) | 80-100 | 80-110 | 80-140 | 80-110 | 80-110 | 80-120 | 80-110 | 80-120 |
| Window Area (µm.g) | 90 | 120 | 280 | 120 | 160 | 200 | 160 | 200 |
| FAB | ++++ | ++++ | ++++ | ++++ | ++ | ++ | +++ | +++ |

| | | | | | | | | |
|---|---|---|---|---|---|---|---|---|
| ++++Excellent, +++ Very good, ++Good, + Fair | | | | | | | | |

FAB stands for free air ball. In this category, the shape and symmetry of the molten drop of wire material hanging at the end of the wire prior to stitch bonding is evaluated. The FAB is excellent when the molten drop of the wire solidifies with spherical and axis-symmetrical ball like shape. Fair describes a molten drop of wire solidify, but the ball size is smaller than the specification and/or tilted.

The process window areas were defined as the product of the respective differences between upper and lower borders of the scrub amplitude and the applied force.

All of the wires 1-5 resulted in process windows which were well suited for industrial application. In particular, inventive wire samples 3 and 5 showed values of more than 200µm.g, which is a significant improvement compared to the 4N Cu wire.

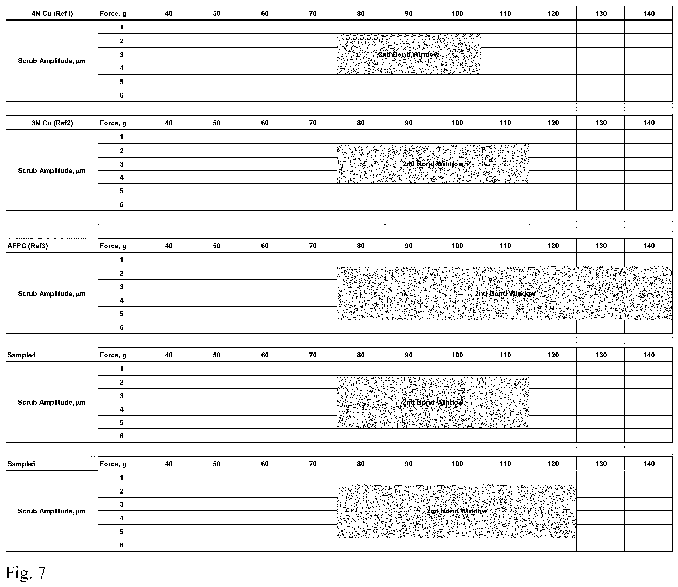

Figure 7 shows a comparison of 2^{nd} bond process window of the wire samples 4 and 5 with the comparative wire samples. The wire of samples 4 and 5 showed a wider 2^{nd} bond process window area than both the comparative samples (Ref1 and Ref2). As well samples 3 and 5 revealed 2^{nd} bond process window of 71% to that of AFPC wire (the best in the industry with respect to 2^{nd} bond window). Attaining such a wide process window of alloyed copper near to AFPC is a substantial improvement for uncoated bare/alloyed copper wire series.

### Example 2:

Wires with gold and palladium content were prepared (Table 3). For a wire with gold and palladium addition, an annealing temperature of 700 °C was found to be the optimum. Other parameters and the method of manufacturing the wire remained unchanged compared to the wire of example 1.

**Table 3: Chemical composition of the copper alloy, wire diameter 18 µm, values in ppm**

| Sample | Ag | Pd | Au | P | Ni | s | Fe | Mn |
|---|---|---|---|---|---|---|---|---|
| 4N Cu (Ref1) | 12 | 0.5 | 0.5 | 1.0 | 1.0 | 2.0 | 2.0 | 0.1 |
| 1N Cu (Ref4) | 10.8 | 12500 | 0.5 | 1.0 | 1.0 | 2.0 | 2.0 | 0.1 |

| Good reliability (1^{st} bond) and better bondability (2^{nd} bond) | | | | | | | | |
|---|---|---|---|---|---|---|---|---|
| 7 | 11.1 | 12600 | 222 | 1.0 | 1.0 | 2.0 | 2.0 | 0.1 |
| 8 | 7.1 | 12480 | 504 | 1.0 | 1.0 | 2.0 | 2.0 | 0.1 |
| 9 | 7.4 | 12500 | 1029 | 1.0 | 1.0 | 2.0 | 2.0 | 0.1 |
| 10 | 225 | 12500 | 0.5 | 1.0 | 1.0 | 2.0 | 2.0 | 0.1 |
| 11 | 498 | 12600 | 0.5 | 1.0 | 1.0 | 2.0 | 2.0 | 0.1 |
| 12 | 250 | 12500 | 250 | 1.0 | 1.0 | 2.0 | 2.0 | 0.1 |
| 13 | 500 | 12500 | 500 | 1.0 | 1.0 | 2.0 | 2.0 | 0.1 |

Table 3 above provides the composition of different samples numbered 7 to 13 of wires of 18 µm diameter. A comparative wire consisting of copper of purity 4N (purity: Cu >= 99.99 wt.%) and 1N (purity: Cu >= 90 wt.%) were included.

**Table 4: 2^{nd} bond (stitch bond) process window**

| Wire sample | 4N Cu (Ref1) | 1N Cu (Ref4) | 7 | 8 | 9 | 10 | 11 | 12 | 13 |
|---|---|---|---|---|---|---|---|---|---|
| Scrub amplitude (µm) | 2-4 | 2-4 | 2-4 | 2-4 | 2-4 | 2-4 | 2-4 | 2-4 | 2-4 |
| Force (g) | 80-100 | 80-100 | 80-110 | 80-110 | 80-110 | 80-110 | 80-110 | 80-110 | 80-110 |
| Window Area (µm.g) | 90 | 90 | 120 | 120 | 120 | 120 | 120 | 120 | 120 |
| FAB | ++++ | ++++ | ++++ | ++++ | ++++ | ++++ | ++++ | ++++ | ++++ |

| | | | | | | | | | |
|---|---|---|---|---|---|---|---|---|---|
| ++++Excellent, +++ Very good, ++Good, + Fair | | | | | | | | | |

All of the inventive wires resulted in process windows which were well suited for industrial application, i.e. the wires showed values of more than 120µm.g. This demonstrated a particular improvement compared to the 4N and 1N Cu comparative wires.

### Example 3:

With reference to the results of example 1 above, similar wires but with a silver content in the range of from 4500 to 10500 ppm, a palladium content in the range of from 4500 to 10500ppm and a phosphorus content in the range of from 40 to 80ppm were prepared.

For a wire with silver, palladium and phosphorus addition, an annealing temperature of 710 °C was found to be the optimum. Other parameters and the method of manufacturing the wire have remained unchanged compared to the wire of example 1.

**Table 5: Chemical composition of the copper alloy, wire diameter 18 µm, values in ppm**

| Sample | Ag | Pd | Au | P | Ni | S | Fe | Mn |
|---|---|---|---|---|---|---|---|---|
| 4N Cu (Ref) | 12 | 0.5 | 0.5 | 1.0 | 1.0 | 2.0 | 2.0 | 0.1 |
| 3N Cu (Ref2) | 225 | 0.5 | 0.5 | 1.0 | 1.0 | 2.0 | 2.0 | 0.1 |
| 1N Cu (Ref4) | 10.8 | 12500 | 0.5 | 1.0 | 1.0 | 2.0 | 2.0 | 0.1 |

| Good reliability (1^{st} bond) and better bondability (2^{nd} bond) | | | | | | | | |
|---|---|---|---|---|---|---|---|---|
| 14 | 4189 | 5070 | 0.5 | 48 | 1.0 | 5.6 | 1.8 | 0.1 |
| 15 | 4330 | 10240 | 0.5 | 48 | 1.0 | 5.5 | 2.1 | 0.1 |
| 16 | 9861 | 5085 | 0.5 | 50 | 1.0 | 3.8 | 1.8 | 0.1 |
| 17 | 9789 | 9909 | 0.5 | 48 | 1.0 | 2.9 | 1.8 | 0.1 |

Table 5 above provides the composition of different samples numbered 14-17 of an inventive wire of 18 µm diameter. Comparative wires consisting of copper with IN, 3N and 4N purity were added.

**Table 6: 2^{nd} bond (stitch bond) process window**

| Wire sample | 4N Cu (Ref1) | 3N Cu (Ref2) | 1N Cu (Ref4) | 14 | 15 | 16 | 17 |
|---|---|---|---|---|---|---|---|
| Scrub amplitude (µm) | 2-4 | 2-4 | 2-4 | 2-5 | 2-4 | 2-4 | 2-4 |
| Force (g) | 80-100 | 80-110 | 80-100 | 80-110 | 80-110 | 80-110 | 80-110 |
| Window Area (µm.g) | 90 | 120 | 90 | 160 | 120 | 120 | 120 |
| FAB | ++++ | ++++ | ++++ | +++ | ++ | ++ | ++ |

| | | | | | | | |
|---|---|---|---|---|---|---|---|
| ++++Excellent, +++ Very good, ++Good, + Fair | | | | | | | |

All of the inventive wires resulted in process windows which were well suited for industrial application. In particular, inventive wire sample 14 showed a value of more than 160µm.g. This demonstrated a significant improvement compared to the comparative wires.

### Test methods

All tests and measurements were conducted at T = 20 °C and a relative humidity RH = 50 %.
a. Average size of crystal grains by line intercept method
   The size of crystal grains was determined using a standard metallographic technique, ASTM E112-96, section 16.3, page 13. A sample of the wires core was cross-sectioned and then etched. In the present case, a solution of 2g FeCl₃ and 6 ml concentrated HCl in 200 ml deionized water was used for the etching. The crystal grain size was determined according to the line intercept principle. The size of a crystal grain in the present context was defined as the longest of all sections of straight lines which passed through the grain. The measured average size of crystal grains was the arithmetic mean of at least seven measurements of crystal grains in the core material. The schematic in Figure 9 illustrates grain size measurement carried out in the present invention as per above mentioned ASTM standard, where G_{FAB} is the grain size of the FAB, G_{W} is the grain size of the Wire, L_{FAB} is the length of the intercept line marked in a FAB, L_{W} is the length of the intercept line marked in the wire, N_{FAB} is the number of grains intersecting the line, and N_{W} is the number of grains intersecting the line.
b. Elongation (EL)
   The tensile properties of the wires were tested using an Instron-5300 instrument. The wires were tested at 1 (one) inch/min speed, for 10 inch gauge length. The load and elongation on fracture (break) were acquired as per ASTM standard F219-96. The elongation was difference in the length of the wire before and after tensile testing, calculated from the recorded load versus extension tensile plot.
c. Vickers Hardness
   The hardness was measured using a Fischer scope H110C testing equipment with a Vickers indenter. A force of 10 mN was applied to a test specimen of wire for a dwell time of 5 s. The testing was performed on the center of the uncoated and annealed wire core.
d. Coating Layer thickness
   For determining the thickness of a coating layer and the average diameter of the core, the wire was cut perpendicular to the maximum elongation of the wire. The cut wire was carefully grinded and polished to avoid smearing of soft materials. A picture was recorded through an optical microscope or a scanning electron microscope (SEM), wherein the magnification was chosen so that the full cross-section of the wire was observed. This procedure was repeated at least 5 times. All values were provided as arithmetic mean of the 5 measurements.
e. Process window area
   Measurements of ball-bonding process window area were done by standard procedure. The test wires were bonded using a KNS-iConn bonder tool (Kulicke & Soffa Industries Inc, Fort Washington, PA, USA). The definition of a 2^{nd} bond process window area for bonding wires was known in the art and was widely used to compare different wires. In principle, it is the product of scrub amplitude and force used in the bonding, wherein the resulting bond has to meet certain pull test specifications, e.g. a pull force of 2.5 grams, no non-stick on lead etc.. The actual value of the 2^{nd} bond process window area of a given wire further depends on the wire diameter as well as the lead finger plated material. In order to give a specific definition of the properties of an inventive wire, the process window value were based on a wire diameter of 18 µm = 0.7 mil, wherein the lead finger consists of silver.
   The four corners of the process window were derived by overcoming the two main failure modes:
   (1) supply of too low force and scrub amplitude lead to non-stick on lead (NSOL) of the wire, and
   (2) supply of too high force and scrub amplitude lead to short tail (SHTL)

   The scope of the inventive system was not limited to wires of this diameter and lead fingers made of silver, but names this data only for definition purpose.
f. Free air ball
   The electric flame off (EFO) current and time defines the specification of the FAB. On EFO firing, the tip of the fractured Cu wire melts and form axi-symmetrical spherical FAB, further stitch the wire on lead frame such that FAB stand on air. This mode of bonding was referred to as cherry pits. The procedures are described in the KNS Process User Guide for Free Air Ball (Kulicke & Soffa Industries Inc, Fort Washington, PA, USA, 2002, 31 May 2009). The FAB diameter was measured using optical microscope at 200X to 500X magnification in micron scale. Morphology of the FAB was observed using scanning electron microscope (SEM).

**Reference Numerals**

| | |
|---|---|
| (1) | wire |
| (2) | core |
| (3) | Coating layer |
| (31) | Layer surface |
| (32) | Center of wire |
| (42) | Surface of further coating layer |
| (5) | Crystal grains |
| (10) | Electric device |
| (11) | Bond pad |
| (15) | surface |
| (17) | Pull hook |
| (18) | Direction of pulling the pull hook |
| (19) | Angle between wire and surface |
| (20) | Substrate |
| (21) | Bond between wire and substrate |
| (22) | Angle of wire under pull hook pulling the wire |
| (23) | Reel |
| (24) | oven |
| (25) | Reel |
| (26) | Wheel |
| L | Imaginary line through cross section of wire |
| T _{ΔL(max)} | Temperature of maximum elongation |
| EL | Elongation |
| ΔL | Elongation value from annealing curve |
| ΔLmax | Maximum Elongation value from annealing curve |
| BL | Break load |
| HV | Unit of Vickers' Hardness |

## Claims

1. A wire (1), comprising a core (2) having a composition consisting of:
a1. silver in an amount in the range of from 0.05 to 1.3 wt.%; or
a2. Palladium, and further at least one element selected from silver and gold, wherein the amount of silver is in the range of from 100 ppm to 1.3 wt.%, wherein the amount of gold is in the range of from 100 to 1500 ppm, and wherein the amount of palladium is in the range of from 0.5 to 1.5 wt.%;
b. copper in the range of from 98 wt.% to 99.95 wt.%;
c. 0 to 100 ppm of further components which are different from the elements silver, gold, palladium and copper;
wherein all amounts in wt.% and ppm are based on the total weight of the core (2);
wherein the core (2) has an average size of crystal grains (5) in the range of from 3 to 30 µm, the average size determined according to the line intercept method;
wherein the wire has an average diameter in the range of from 8 to 80 µm;
wherein the core (2) has a surface (15), wherein a coating layer (3) is superimposed over the surface (15) of the core (2);
wherein the coating layer (3) is composed of at least one element selected from the group consisting of palladium, platinum and silver;
wherein a further coating layer (4) is superimposed over the coating layer (3);
wherein gold is the component of the further coating layer (41).

2. The wire (1) according to claim 1, wherein the core (2) comprises phosphorus in the range of from 40 to 80 ppm, based on the total weight of the core (2).

3. The wire (1) according to any one of the precedent claims, wherein the ratio between the diameter of the core (2) and the average size of crystal grains in the core is in the range of from 2 to 10.

4. The wire (1) according to claim 3, wherein the mass of the coating layer (3) is not more than 2.5 wt.% with respect to the total mass of the core (2).

5. The wire (1) according to claim 4, wherein the mass of the further coating layer (4) is not more than 0.2 wt.% with respect to the total mass of the core (2).

6. The wire (1) according any one of the precedent claims, characterized at least by one of the following features:
α) The elongation value ΔL of the wire (1) is not more than 95 % with respect to the maximum elongation ΔL_{max;}
β) The hardness of the wire core (2) is not more than 105 HV (0.01N/5s).
γ) The process window area for stitch bonding has a value of at least 200 µm*g provided the wire (1) has a diameter of 18 µm.

7. A method for manufacturing the wire (1) according to any one of claims 1 to 6, comprising at least the steps of
i. Providing a precursor item having a composition consisting of:
a1. silver in an amount in the range of from 0.05 to 1.3 wt.%; or
a2. Palladium, and further at least one of silver and gold,
wherein the amount of silver is in the range of from 100 ppm to 1.3 wt.%,
wherein the amount of gold is in the range of from 100 to 1500 ppm, and
wherein the amount of palladium is in the range of from 0.5 to 1.5 wt.%;
b. copper in the range of from 98 wt.% to 99.95 wt.%;
c. 0 to 100 ppm of further components which are different from the elements silver, gold, palladium and copper;
wherein all amounts in wt.% and ppm are based on the total weight of the core (2);
ii. elongating the precursor item to a wire precursor (1a);
iii. annealing the wire precursor (1a);
whereby the wire (1) is obtained.

8. The method of claim 7, wherein the precursor item further comprises phosphorus in the range of from 40 to 80 ppm.

9. The method of claim 7 or 8, wherein the annealing is strand annealing.

10. The method of any one of claims 7 to 9, wherein step iii. is performed under at least one of the following conditions:
aa. at a temperature in the range of from 570 to 740 °C, or
bb. for a period in the range of from 0.1 s to 0.4 s, or
cc. at a temperature in the range of from 570 to 740 °C and for a period in the range of from 0.1 s to 0.4 s.

11. The method of any one of claims 7 to 10, wherein step iii. is performed at a temperature which is at least 10 °C higher than the temperature of maximum elongation T_{ΔL(max)}.

12. An electric device (10) comprising at least
(1) a first bonding pad (11);
(2) a second bonding pad (11); and
(3) the wire (1) according to any one of claims 1 to 6, or a wire obtainable by the method according to anyone of claims 7 to 11;
wherein the wire (1) is electrically connected to at least one of the bonding pads (11).

## Patentansprüche

1. Draht (1), umfassend einen Kern (2) mit einer Zusammensetzung, bestehend aus:
a1. Silber in einer Menge im Bereich von 0,05 bis 1,3 Gew.-%; oder
a2. Palladium und ferner mindestens ein Element, ausgewählt aus Silber und Gold,
wobei die Menge an Silber im Bereich von 100 ppm bis 1,3 Gew.-% liegt,
wobei die Goldmenge im Bereich von 100 bis 1500 ppm liegt, und
wobei die Menge an Palladium im Bereich von 0,5 bis 1,5 Gew.-% liegt;
b. Kupfer im Bereich von 98 Gew.-% bis 99,95 Gew.-%;
c. 0 bis 100 ppm weiterer Komponenten, die sich von den Elementen Silber, Gold, Palladium und Kupfer unterscheiden;
wobei alle Mengen in Gew.-% und ppm auf das Gesamtgewicht des Kerns (2) bezogen sind;
wobei der Kern (2) eine durchschnittliche Größe von Kristallkörnern (5) im Bereich von 3 bis 30 µm aufweist, wobei die durchschnittliche Größe gemäß dem Linienabfangverfahren bestimmt wird;
wobei der Draht einen durchschnittlichen Durchmesser im Bereich von 8 bis 80 µm aufweist;
wobei der Kern (2) eine Oberfläche (15) aufweist, wobei eine Beschichtungsschicht (3) über der Oberfläche (15) des Kerns (2) angeordnet ist;
wobei die Beschichtungsschicht (3) aus mindestens einem Element besteht, ausgewählt aus der Gruppe bestehend aus Palladium, Platin und Silber;
wobei eine weitere Beschichtungsschicht (4) über der Beschichtungsschicht (3) angeordnet ist;
wobei Gold die Komponente der weiteren Beschichtungsschicht (41) ist.

2. Draht (1) nach Anspruch 1, worin der Kern (2) Phosphor im Bereich von 40 bis 80 ppm, bezogen auf das Gesamtgewicht des Kerns (2), umfasst.

3. Draht (1) nach einem der vorhergehenden Ansprüche, wobei das Verhältnis zwischen dem Durchmesser des Kerns (2) und der durchschnittlichen Größe der Kristallkörner im Kern im Bereich von 2 bis 10 liegt.

4. Draht (1) nach Anspruch 3, wobei die Masse der Beschichtungsschicht (3) nicht mehr als 2,5 Gew.-%, bezogen auf die Gesamtmasse des Kerns (2), beträgt.

5. Draht (1) nach Anspruch 4, wobei die Masse der weiteren Beschichtungsschicht (4) nicht mehr als 0,2 Gew.-%, bezogen auf die Gesamtmasse des Kerns (2), beträgt.

6. Draht (1) gemäß einem der vorhergehenden Ansprüche, **gekennzeichnet durch** mindestens eines der folgenden Merkmale:
α) Der Dehnungswert ΔL des Drahtes (1) beträgt nicht mehr als 95 % bezogen auf die maximale Dehnung ΔL_{max;}
β) Die Härte des Drahtkerns (2) beträgt nicht mehr als 105 HV (0,01N/5s).
γ) Der Prozessfensterbereich für das Stichbonden hat einen Wert von mindestens 200 µm*g, sofern der Draht (1) einen Durchmesser von 18 µm hat.

7. Verfahren zur Herstellung des Drahtes (1) nach einem der Ansprüche 1 bis 6, umfassend mindestens die Schritte von
i. Bereitstellen eines Vorläufergegenstandes mit einer Zusammensetzung, bestehend aus:
a1. Silber in einer Menge im Bereich von 0,05 bis 1,3 Gew.-%; oder
a2. Palladium und ferner mindestens eines aus Silber und Gold,
wobei die Menge an Silber im Bereich von 100 ppm bis 1,3 Gew.-% liegt,
wobei die Goldmenge im Bereich von 100 bis 1500 ppm liegt, und
wobei die Menge an Palladium im Bereich von 0,5 bis 1,5 Gew.-% liegt;
b. Kupfer im Bereich von 98 Gew.-% bis 99,95 Gew.-%;
c. 0 bis 100 ppm weiterer Komponenten, die sich von den Elementen Silber, Gold, Palladium und Kupfer unterscheiden;
wobei alle Mengen in Gew.-% und ppm auf das Gesamtgewicht des Kerns (2) bezogen sind;
ii. Verlängern des Vorläuferteils zu einem Drahtvorläufer (1a);
iii. Glühen des Drahtvorläufers (1a);
wobei der Draht (1) erhalten wird.

8. Verfahren nach Anspruch 7, worin das Vorläuferprodukt ferner Phosphor im Bereich von 40 bis 80 ppm umfasst.

9. Verfahren nach Anspruch 7 oder 8, worin das Glühen ein Strangglühen ist.

10. Verfahren nach einem der Ansprüche7 bis 9, worin Schritt iii. unter mindestens einer der folgenden Bedingungen durchgeführt wird:
aa. bei einer Temperatur im Bereich von 570 bis 740 °C, oder
bb. für einen Zeitraum im Bereich von 0,1 s bis 0,4 s, oder
cc. bei einer Temperatur im Bereich von 570 bis 740 °C und für einen Zeitraum im Bereich von 0,1 s bis 0,4 s.

11. Verfahren nach einem der Ansprüche 7 bis 10, worin Schritt iii. bei einer Temperatur durchgeführt wird, die mindestens 10 °C höher ist als die Temperatur der maximalen Dehnung T_{ΔL(max)}.

12. Eine elektrische Vorrichtung (10), die mindestens Folgendes umfasst
(1) ein erstes Klebepad (11);
(2) eine zweite Verbindungsplatte (11); und
(3) einen Draht (1) nach einem der Ansprüche 1 bis 6 oder einen Draht, der durch ein Verfahren nach einem der Ansprüche 7 bis 11 erhältlich ist;
wobei der Draht (1) elektrisch mit mindestens einem der Klebepads (11) verbunden ist.

## Revendications

1. Fil (1), comprenant une âme (2) ayant une composition constituée de :
a1. de l'argent en une quantité comprise entre 0,05 et 1,3 % en poids ; ou
a2. Palladium, et en outre au moins un élément choisi parmi l'argent et l'or,
dans laquelle la quantité d'argent est comprise entre 100 ppm et 1,3 % en poids,
dans laquelle la quantité d'or est comprise entre 100 et 1500 ppm, et
dans laquelle la quantité de palladium est comprise entre 0,5 et 1,5 % en poids ;
b. du cuivre dans la plage de 98 % en poids à 99,95 % en poids ;
c. 0 à 100 ppm d'autres composants différents des éléments argent, or, palladium et cuivre ;
dans laquelle toutes les quantités en % en poids et ppm sont basées sur le poids total de l'âme (2) ;
dans laquelle l'âme (2) a une taille moyenne de grains cristallins (5) dans la gamme de 3 à 30 µm, la taille moyenne étant déterminée selon le procédé d'interception de lignes ;
dans laquelle le fil a un diamètre moyen dans la gamme de 8 à 80 µm ;
dans laquelle l'âme (2) a une surface (15), dans laquelle une couche de revêtement (3) est superposée sur la surface (15) de l'âme (2) ;
dans laquelle la couche de revêtement (3) est composée d'au moins un élément choisi dans le groupe consistant en palladium, platine et argent ;
dans laquelle une autre couche de revêtement (4) est superposée à la couche de revêtement (3) ;
dans laquelle l'or est le composant de la couche de revêtement supplémentaire (41).

2. Fil (1) selon la revendication 1, dans lequel l'âme (2) comprend du phosphore dans la plage de 40 à 80 ppm, par rapport au poids total de l'âme (2).

3. Fil (1) selon l'une quelconque des revendications précédentes, dans lequel le rapport entre le diamètre de l'âme (2) et la taille moyenne des grains cristallins dans l'âme est compris entre 2 et 10.

4. Fil (1) selon la revendication 3, dans lequel la masse de la couche de revêtement (3) n'est pas supérieure à 2,5 % en poids par rapport à la masse totale de l'âme (2).

5. Fil (1) selon la revendication 4, dans lequel la masse de la couche de revêtement supplémentaire (4) n'est pas supérieure à 0,2 % en poids par rapport à la masse totale de l'âme (2).

6. Le fil (1) selon l'une quelconque des revendications précédentes, **caractérisé par** au moins l'une des caractéristiques suivantes :
α) La valeur d'allongement ΔL du fil (1) n'est pas supérieure à 95 % par rapport à l'allongement maximal ΔL_{max ;}
β) La dureté du fil (2) n'est pas supérieure à 105 HV (0,01N/5s).
γ) La surface de la fenêtre de processus pour le collage de points a une valeur d'au moins 200 µm*g à condition que le fil (1) ait un diamètre de 18 µm.

7. Procédé de fabrication du fil (1) selon l'une quelconque des revendications 1 à 6, comprenant au moins les étapes suivantes
i. Fourniture d'un précurseur ayant une composition consistant en :
a1. de l'argent en une quantité comprise entre 0,05 et 1,3 % en poids ; ou
a2. Palladium, et en outre au moins un d'argent et d'or,
dans laquelle la quantité d'argent est comprise entre 100 ppm et 1,3 % en poids,
dans laquelle la quantité d'or est comprise entre 100 et 1500 ppm, et
dans laquelle la quantité de palladium est comprise entre 0,5 et 1,5 % en poids ;
b. cuivre dans la plage de 98 % en poids à 99,95 % en poids ;
c. 0 à 100 ppm d'autres composants différents des éléments argent, or, palladium et cuivre ;
dans laquelle toutes les quantités en % en poids et ppm sont basées sur le poids total de l'âme (2) ;
ii. l'allongement de l'élément précurseur en un fil précurseur (la) ;
iii. recuit du précurseur de fil (la) ;
où le fil (1) est obtenu.

8. Procédé selon la revendication 7, dans lequel l'élément précurseur comprend en outre du phosphore dans la plage de 40 à 80 ppm.

9. Procédé selon la revendication 7 ou 8, dans lequel le recuit est un recuit de brin.

10. Procédé selon l'une quelconque des revendications7 à 9, dans lequel l'étape iii. est réalisée dans au moins l'une des conditions suivantes :
aa. à une température comprise entre 570 et 740 °C, ou
bb. pendant une période comprise entre 0,1 s et 0,4 s, ou
cc. à une température comprise entre 570 et 740 °C et pendant une durée comprise entre 0,1 s et 0,4 s.

11. Procédé selon l'une quelconque des revendications 7 à 10, dans lequel l'étape iii. est réalisée à une température qui est supérieure d'au moins 10 °C à la température d'allongement maximal T_{ΔL(max)}.

12. Dispositif électrique (10) comprenant au moins
(1) une première plot de liaison (11) ;
(2) une deuxième plot de liaison (11) ; et
(3) un fil (1) selon l'une quelconque des revendications 1 à 6, ou un fil pouvant être obtenu par un procédé selon l'une quelconque des revendications 7 à 11 ; dans laquelle le fil (1) est connecté électriquement à au moins l'une des plots
de liaison (11).
